# EUROPEAN PATENT APPLICATION

(11) **EP 2 009 670 A1**
(43) Date of publication of application: **31.12.2008**
(21) Application number: 07111326.0
(22) Date of filing: 28.06.2007
(51) Int. Cl.: H01J 37/34

(54) **Sputtering Device, Magnetron Electrode and Electrode Arrangement**

(71) Applicant: Applied Materials, Inc., Santa Clara, CA 95054 (US)
(72) Inventor: Lopp, Andreas, 63579, Freigericht-Somborn (DE); Haas, Dieter, 63486, Bruchköbel (DE); White, John M. c/o Applied Materials Inc.,, Santa Clara, CA 95054 (US); Stimson, Brad c/o Applied Materials Inc.,, Santa Clara, CA 95054 (US)
(74) Representative: Lang, Christian

(57) **Abstract**

The present invention refers to a planar magnetron electrode for a sputtering device comprising a planar elongated electrode with a target surface, at least a magnet arrangement assigned to the electrode having a carrier and at least a row of magnets or an elongated magnet arranged at said carrier with the magnet pole of a first polarity facing toward the electrode and the magnet pole of the other polarity facing away from the electrode, said magnet arrangement being movable relative to the electrode along a path of movement, wherein said path of movement of said magnet arrangement is restricted to an area of the electrode such that the magnet arrangement does not project beyond the electrode seen from a direction perpendicular to the target surface of the electrode, while the magnetic field projects beyond the circumference of the magnet arrangement such that a plasma can be generated in front of the electrode, said plasma extending in the radial outer marginal area of the electrode and/or beyond the circumference of the electrode seen from a direction perpendicular to the target surface of the electrode.

Further, the invention relates to an electrode arrangement with at least two planar electrodes alternating as sputtering cathode (2, 3), which are arranged adjacent to each other along their lengths, with the electrodes held by at least one, preferably two or more joint holders, at the long side, such that a narrow gap is formed between them.

## Description

BACKGROUND OF THE INVENTION

FIELD OF THE INVENTION

The present invention refers to a magnetron electrode and an electrode arrangement for a sputtering device as well as to the sputtering device itself.

PRIOR ART

Coating machines working on the principle of sputtering are known from prior art. In such devices, the material for sputtering is arranged as cathode or in front of a cathode, such that ions are accelerated from a plasma ignited in the sputtering device onto the cathode in order that the target arranged there may be sputtered. Behind the cathode may especially be provided a mobile magnet arrangement (magnetron electrode), which, through the formation of a magnetic field in front of the target surface, leads to the formation of plasma channels or so-called race tracks, which contribute to more effective sputtering.

In the case of large-area coatings, such as are required, for example, in architectural glazing and the like, having coating areas > 1 m², the difficulties include, on one hand, depositing a uniform layer on the substrate, and, on the other, fully exploiting the target material's surface. Additionally, the problem arises that deposition of the target material on the anodes and targets (so-called redeposition) may lead to spalling and thus to particle formation with increasing coating. Further, charging of the target material may lead to problems.

These problems may be advantageously avoided by alternately operating pairs of electrodes as cathode and anode, such that corresponding deposition on the anodes with corresponding spalling is avoided. Admittedly, here again, deposits may be formed on a part of the target's surface. A corresponding device and method for solving these problems are described, for example, in PCT/EP2006/062833, which is fully included into the application by way of reference. However, efficient exploiting of the target material is still a need.
For dealing with these problems, different magnet arrangements for magnetron electrodes are also known from prior art. For example, DE 101 38 165 A1, DE 102 34 858 A1 and DE 40 16 505 A1 describe various magnet arrangements by which redeposition of target material should be avoided and a homogeneous coating as well as efficient sputtering of the target may be achieved.

However, the problem still remains that improvements are necessary to achieve, on one hand, full and uniform exploitation of the target material and, on the other, uniform coating of the substrate.

DISCLOSURE OF THE INVENTION

OBJECT OF THE INVENTION

It is therefore the object of the present invention to provide a sputtering device and a magnetron electrode as well as an electrode arrangement by which uniform coating may be obtained through effective and thus extensive exploitation of the target material, especially in the case of large-area coatings that are performed especially stationary, i.e. with the substrate at rest. Additionally, the devices are to have the simplest possible designs, be easy to manufacture, as well as be simple to operate and maintain.

TECHNICAL SOLUTION OF THE INVENTION

These objects are achieved with a magnetron electrode having the features of claim 1, an electrode arrangement having the features of claims 25, 27 or 34 as well as a sputtering device having the features of claim 39. Advantageous embodiments are the subject of the dependent claims.

The invention starts with a magnetron electrode of a sputtering device which comprises a magnet arrangement that allows for ignition of a plasma not only straight ahead in front of the magnet arrangement but laterally offset, especially in the direction of movement of the magnet arrangement or in the direction towards an adjacent electrode arranged laterally at a side of a electrode, especially at the length side of the electrode.

The planar magnetron electrode according to the invention comprises a planar elongated electrode in form of an oblong plate having a length which is much greater than the width thereof. Such an electrode comprises a target surface on which a target to be sputtered can be mounted. Alternatively, the target may be used as electrode itself so that the electrode surface is identical to the target surface.

As definition for the present specification the target surface corresponds to the principal surface of the plate-like electrode, while the sides perpendicular to the principal surface are nominated as lateral sides. The lateral sides comprise four face sides, namely two longitudinal sides and two front sides. This definition also applies to a separate target and/or the magnet arrangement.

The magnetron electrode further comprises a magnet arrangement being movable relative to the electrode along a path of movement which preferably extends transverse to the length of the electrode. However, the path of movement may also extend parallel to the length of the electrode or in any other configuration. The magnet arrangement may be movable partially or as a whole.

The magnet arrangement comprises at least a carrier and at least a row of magnets or an elongated magnet being arranged at the carrier. The magnets of the at least one row are oriented parallel with respect to their polarity so that either all south poles of the magnets are directed towards the electrode or target or all north poles, respectively. As described below in more detail magnets additional to that of the at least one row of magnets may be disposed in the same or different orientation. If only one row of magnets having the same orientation with respect to polarity is present the magnetic field lines extend from the side facing the electrode in a curved manner to the backside of the magnet arrangement. Thus, the plasma will be focused at a lateral side of the magnet arrangement.

The path of movement of the magnet arrangement may be restricted to an area of the electrode such that the magnet arrangement does not project beyond at least one side , preferably the length side of the electrode seen from the direction transverse or perpendicular to the target surface of the electrode. Accordingly, the dimensions of the magnet arrangement, at least in a plane, preferably all planes parallel to the plane of the electrode or the target, can be smaller than the extension of the electrode, preferably at least in the direction of movement of the magnet arrangement, especially transverse to the length side according to one embodiment of the invention. However, the dimensions of the magnet arrangement can be greater than the extension of the electrode, particularly at least in the direction of movement of the magnet arrangement, especially in the direction of the length of the electrode according to a second embodiment of the invention.

Although the movement of the magnet arrangement may be restricted such that the magnet arrangement does not project beyond at least one side of the electrode during movement, the magnetic field projects beyond the lateral circumference of the magnet arrangement at the same time in a way to allow ignition of the plasma in front of the outer marginal area of the above-mentioned side of the electrode and/or projects beyond this side of the electrode. Accordingly, it is achieved that a plasma is generated in front of the electrode or target at the rim of the electrode, although the magnet arrangement is spaced apart from the respective edge of the electrode or does at least not overlap this side of the electrode. Thus, it is possible to provide structural components at the margin of the electrode which extend perpendicular to the target surface of the electrode, like holders, stiffening elements or the like. This is advantageous especially with respect to planar electrodes having a huge extension in the length direction. Accordingly, holders or stiffening elements can be disposed at the rim of the electrode ensuring an exact planar alignment of the target surface even in the case of electrodes with large length.

Further, such a design of a planar magnetron electrode allows for very narrow arrangements of adj acent electrodes in an electrode arrangement, in order to reduce the so-called dark space gap between adjacent electrodes which does not contribute to a sputtering of coating material, for example in alternately switched cathodes.

Although, it is mentioned that the magnet arrangement does not project above or overlap at least one lateral side of the electrode, it is understood that this condition can be fulfilled for two, three or all lateral sides of the electrode. However, this condition has only to be fulfilled at the side of the electrode being adjacent to the neighbouring electrode to minimize the dark space gap or at the side where structural components like holders, stiffening elements or the like have to be disposed.

The magnets of the magnet arrangement may be arranged in one, two or several parallel rows along the length of the carrier, and/or in a circumferential or peripheral ring arrangement. Further, several parallel rings of magnets are also conceivable at the centre or inner regions of the carrier. The rings may be closed or open so as to form partial rings.

Preferably, all magnets of a ring or row, especially of several rows of a magnet arrangement may be oriented parallel regarding the polarity. Thus, for a peripheral annular magnet arrangement for example a magnetic field distribution is achieved which allows for a lateral plasma generation as required by the invention.

Generally, two kinds of magnet arrangements are preferred. In the first case the rows, rings and/or partial rings of magnets are aligned with the longitudinal axis of the magnet arrangement being parallel to the length direction of the electrode. In this case the path of movement of the magnet arrangement is transverse to the longitudinal direction of the electrode. The other preferred embodiment of the magnet arrangement comprises a plurality of partial magnet arrangements each of the magnet arrangements being aligned with its longitudinal axis of the rows, rings or partial rings of magnets transverse to the longitudinal axis of the electrode. In this case the path of movement is parallel to the length of the electrode.

The magnet arrangements or partial magnet arrangements can comprise a magnetic yoke connecting the magnets and enforcing the magnetic properties of the magnet arrangement. Preferably, the carrier can be designed as yoke.

The magnets may be arranged in one or several rows centrally to the carrier and/or yoke, and, especially, centrally as regards the width direction, that is, transverse to the length extension. This produces a magnetic field symmetrical to the longitudinal axis of the yoke.

Further, the magnets may be arranged in a ring and a row being disposed within the ring. Such a magnet arrangement or partial magnet arrangement may be aligned parallel or transverse to the longitudinal axis of the electrode or carrier.

Especially, in an embodiment where partial magnet arrangements with a ring and a row of magnets within the ring the ring may be designed as a partial ring having an open end, i.e. an area in which magnets are omitted so that the ring is not closed. Preferably, the partial magnet ring may be designed such that two open ends in an opposing fashion are provided for at the length sides of the electrode or carrier, respectively.

The missing magnets for closing the ring can be disposed in an adjacent magnet arrangement of a neighbouring electrode in order to extend or stretch the magnetic field over a lateral side of the magnet arrangement or electrode, respectively, so that the plasma ignited in the area of the magnetic field is also extended or stretched beyond the lateral side of the electrode or target, respectively. Accordingly, the magnet arrangement of the planar magnetron electrode may comprise additional magnets in the region of the longitudinal sides. These additional magnets close the rings of partial magnet rings of neighbouring magnet arrangements.

The yoke can be formed such that the magnetic field covers areas especially at the edge of the target as well. Above and beyond that, the magnetic field is adjusted such that an effective magnetic effect is obtained in the area in front of the target. To this end, the yoke is formed as a plate, which, especially in accordance with the electrodes, may be formed as an oblong plate for large-area coating. This plate has a first principal surface and a second principal surface opposite to it, with the magnets arranged at one of the principal surfaces. To facilitate wide projection of the magnetic field over the face sides, especially at the longitudinal sides of the electrode, an inclined surface is provided at at least one, preferably two or four, especially all face sides of the plate that is assigned to the principal surface at which the magnets are arranged. Correspondingly, the surface normal of the inclined surface of the plate has a sub-vector, which is parallel to the surface normal of the second principal surface of the plate with the magnets.

The inclined surface may enclose an angle of 30 to 60°, especially an angle in the region of 45°, with the principal surface at which the magnets are arranged.

In a further embodiment, magnets oriented in a direction opposite to or anti-parallel to the magnets arranged at the principal surface may be provided at the inclined surfaces in order that the magnetic field formation may be amplified.

The magnets can be disposed at the principal surface and/or the inclined surface of the yoke or the carrier. The magnets disposed in between the magnets of the principal surface and of the inclined surface may be gradually or stepwise rotated so as to gradually or stepwise change the alignment of the magnets between the position of the magnets at the inclined surface and at the principal surface.

The provision of an inclined surface at the face sides of the carrier or yoke of the magnet arrangement leads to the advantage that the installed height of the magnet arrangement at at least one face side is lower than at the rest of the magnet arrangement. Accordingly, the inlet and exit points of the magnetic field lines differ with respect to the level of the inlet and exit points in planes parallel to the principal surface. Due to the reduced installed height at at least one face side of the magnet arrangement the magnet arrangement can be disposed very close to an holder or a similar element of the electrode arranged at that side or can be moved very close to such an element. At the same time it is achieved that the magnetic field in front of the electrode or target, respectively, extends beyond the face side so that the whole target material can be used for deposition.

Above and beyond that, means may be provided for moving the magnet arrangement. The movement of the magnet arrangement can be carried out in a direction transverse or parallel to the length of the electrode.

Since the movement of the magnet arrangement shall ensure that the whole target surface is sputtered the movement direction depends on the alignment of the magnets in the magnet arrangement. In the case where the rows and rings of magnets are arranged with their longitudinal axis parallel to the length of the electrode the movement direction may be transverse to the length of the electrode, while for a magnet arrangement with the rows and/or rings aligned transverse to the length of the electrode the movement direction may be parallel to the length of the electrode.

In the first case the magnetic field lines overlap the face sides transverse to the direction of movement, while in the second case the magnetic field lines overlap the face sides parallel to the movement direction.

The magnet arrangement of the invention ensures that the magnetic field is present over a wide and effective area. Especially, the magnetic field may extend beyond the face sides of the magnet arrangement corresponding to the sides of the carrier and/or yoke, i.e. the boundaries of the magnet arrangement, and/or of the electrode or target, with the magnet arrangement being able to be arranged very close to the edge of an electrode arrangement or to be moved towards it.

The use of the above-described magnet arrangements is especially advantageous in combination with an electrode arrangement, which, through its design, also facilitates disposition of magnet arrangements in the edge area of the electrodes. Above and beyond that, a further embodiment of the invention ensures by means of the electrode design of the invention that, despite large lateral extension, very thin electrodes may be used, which therefore effectively facilitate the provision of an adequately strong magnetic field in the space in front of the target.

Moreover, according to a further aspect, it is avoided by the design of the electrode arrangement that in large areas, where there is no target material, non-uniform coating occurs on a substrate being stationary opposite the sputtering device during coating.

Correspondingly, according to a first aspect, at least a j oint holder for two adjacent electrodes is provided at the long sides of the electrodes, along which they are arranged adjacent to each other, said holder preventing the electrodes from having too large installed heights due to self-supporting design and thus weakening the magnetic field in front of the target. Simultaneously, the joint holder for adjacent electrodes allows that the thickness or width of the holder may be kept small in order that an arrangement of magnets may be facilitated such that overlapping of the magnetic field is obtained at the edge of the electrodes.

Correspondingly, according to a second aspect, only a very small and narrow gap is formed between the electrodes, which are held jointly by the holder, said gap in turn leading to the fact that only a small area with a so-called dark space is present in which no target material for sputtering is present. Correspondingly, this also prevents non-uniform coatings on the substrate. The gap between the electrodes is set to values of 0.1 to 5 mm, in particular 0.1 to 3 mm, preferably 0.2 to 3 mm or 0.1 to 0.9 mm and especially 0.2 to 2 mm, more preferably 0.2 to 0.5 mm or 0.5 to 2mm, most preferably 0.2 to 0.8 mm or 0.5 to 0.6 mm.

The gap may be filled with the atmosphere present in the sputtering device or vacuum chamber or with other insulating materials.

Those sides of the electrodes which face away from the target, that is, opposite the sputtering side, may have an electrical insulator as well as a sealing device, which atmospherically seals off the magnet-side rear space of the electrodes, i.e. the side of the electrodes facing away from the target, from the space facing the target side. This has the advantage that, in the magnet space, a higher pressure can be set, which contributes to the avoidance of discharges.

The seal may be provided by appropriate sealing means, such as o-rings or appropriately elastic sealing strips and the like, with especially the sealing means provided adj acent to the gap between the electrodes. There, the sealing means may be arranged in a part of the electrode, a part of the joint holder or separate receptacles.

The joint holder for the electrodes may have at least one sub-area whose width is dimensioned to be so small that magnet arrangements may be arranged in the vicinity of the long side or be traversed close to this, such that the magnetic field can effectively cover the whole area of the target, especially in the region of the long edges as well.

The holder may comprise a T-profile or a double T-profile, with the means for mounting the electrodes and/or for mounting the holder to a chamber wall provided in the wider areas of the holder.

Alternatively, the holder may have a structure with at least one region of reduced width extension comparable to the reduced width of a double T-structure. Such a holder makes sure that the magnet arrangement may be disposed close to the face side of the electrode where the holder is fixed in order to allow the magnetic field lines to project above the face side. Accordingly, the region of reduced width extension may have a height corresponding at least to the installed height of a magnet arrangement assigned to that electrode.

The holder may also comprise a separation element extending between the electrodes and/or the targets in order to ensure an effective separation of adjacent electrodes and/or targets.

According to a further aspect of the invention for which in connection with the aspects described above or for itself alone protection is sought, the magnet arrangement assigned to one electrode comprises magnets associated to the magnet arrangement of an adjacent electrode so that the magnetic field lines project above the lateral sides of the adjacent electrode without need to design a magnet arrangement overlapping the electrode in the same direction. Thus, two neighbouring electrodes interact with respect to their magnet arrangement in a way such that the magnet arrangement of the one electrode complements the magnet arrangement of the adjacent electrode, and preferably vice versa. Due to the fact that the magnet arrangements of the electrodes do not overlap the adj acent electrode very large and thin electrodes having a small dark space gap in between may be realized.

An embodiment implementing such principles may comprise several partial rings of magnets being disposed parallel to each other along the length of the first electrode with the longitudinal direction of the rings being transverse to the length of the first electrode. Such an embodiment of a planar magnetron electrode has been already disclosed above. The partial rings of magnets further comprise a central row of magnets within the partial ring with the magnets of the row having an opposite orientation with respect to polarity compared to the magnets of the partial ring. Such partial magnet arrangements disposed adj acent to each other may embed additional magnets located between adjacent rings and having the same orientation with respect to polarity as the magnets of the adjacent magnet rings. These additional magnets are effective with respect to the neighbouring magnet arrangement of an adjacent electrode. Accordingly, a corresponding magnet arrangement is provided for at the neighbouring electrode. Thus, the magnet arrangements of adjacent electrodes interact with each other in order to comply with the requirement for magnetic field coverage of the whole target surface.

In order to facilitate mutual cooperation of adjacent magnet arrangements the adjacent electrodes and/or assigned magnet arrangements may be offset to each other with respect to their face sides, especially front faces.

Alternatively or additionally, the rows, rings and/or partial rings of the magnet arrangements may be inclined to the width direction of the electrode.

The magnet arrangements of adjacent electrodes may be driven synchronously or may be arranged at a common carrier so that the movement of the interacting magnet arrangements is adjusted.

With a corresponding sputtering device in which the magnet arrangement and/or the electrode arrangement of the invention are realised, it is thus possible in the case of stationary coating to provide large-area substrates with a very uniform coating using a large portion of the target material, and to largely avoid the problem of redeposition.

### BRIEF DESCRIPTION OF FIGURES

Further advantages, characteristics and features of the present invention are apparent from the following detailed description of embodiments using the enclosed drawings. The drawings show in purely schematic form:
- Fig. 1: a cross-section of a part of a magnetron arrangement in a vacuum chamber;
- Fig. 2: a second embodiment of a magnetron arrangement following the embodiment of Fig. 1;
- Fig. 3: a third embodiment of a magnetron arrangement following the embodiment of Figs. 1 and 2;
- Fig. 4: a fourth embodiment of a magnetron arrangement following the embodiments of Figs. 1 to 3;
- Fig. 5: a fifth embodiment of a magnetron arrangement following the embodiments of Figs. 1 to 4;
- Fig. 6: a sixth embodiment of a magnetron arrangement following the embodiments of Figs. 1 to 5;
- Fig. 7: a seventh embodiment of a magnetron arrangement following the embodiments of Figs. 1 to 6;
- Fig. 8: a side view of an eighth embodiment of a magnetron arrangement according to the present invention;
- Fig. 9: a top view of an electrode arrangement according to the present invention;
- Fig. 10: a detail view of the embodiment shown in Fig. 9;
- Fig. 11: a top view of an electrode arrangement similar to that one of Fig. 9; and in
- Fig. 12: a presentation of prior art.

PREFERRED EMBODIMENTS

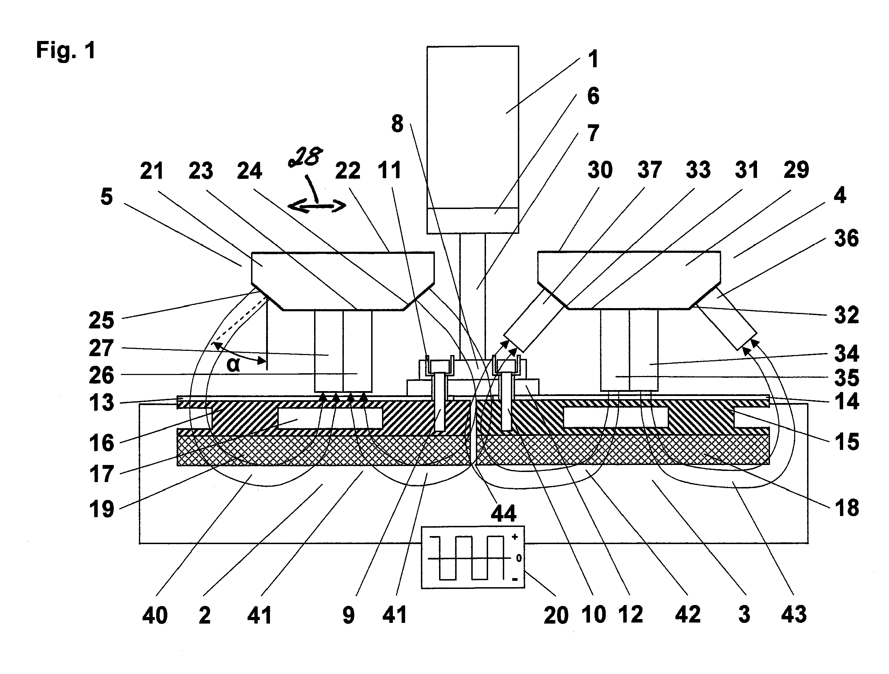

Fig. 1 is a schematic cross-sectional view of a part of a magnetron arrangement for a sputtering device, wherein the vacuum chamber in which the magnetron arrangement is accommodated, is not shown.

Fig. 1 shows two electrodes 2 and 3, which are adjacent to each other but separated by a narrow gap 44 and which are held along their long sides by a joint holder 1. The electrodes 2 and 3 are designed as flat, oblong plates, with the length direction extending perpendicularly to the plane of the diagram. Correspondingly, the thickness direction of the electrodes in Fig. 1 is parallel to the vertical, whereas the width direction is aligned parallel to the horizontal.

The joint holder 1 may be formed as a single, continuous bar, which also extends perpendicularly to the plane of the diagram. Alternatively, it is also possible for several holders 1 to be provided behind each other along the length of the electrodes. Additional holders of the electrodes 2 and 3, which may, e.g., be provided at the other sides, are not shown.

The holder 1 has essentially a cross-section in the shape of a double T, with the top part 6 for arrangement at the vacuum chamber wall and the bottom part 8 are connected to each other by a narrow base 7 or a correspondingly narrow plate.

The bottom part 8 has openings for accommodating screws 9 and 10, by means of which the electrodes 2 and 3 are mounted to the holder 1. Insulation materials 11 are preferably provided between the bottom part 8 of holder 1 and the screws 9 and 10 to ensure that the holder 1 is electrically insulated from the electrodes 2, 3.

The electrodes 2 and 3 are identical and, as regards the plane in which the joint holder 1 is arranged, have a mirror-symmetrical design. The electrodes 2 and 3 each comprise a holding plate 15 and 16 in which are provided cooling channels 17 for conveying a cooling medium, especially water.

The holding plates 15 and 16 serve to accommodate the coating material for sputtering or a corresponding starting material in the form of a so-called target 18 or 19. The targets 18 and 19 are arranged at a principal surface of the holding plates 15 and 16.

On the opposite principal surface are provided insulators 13 and 14 in the form of thin plates or films. In the vicinity of the holder 1, the insulators 13 and 14 are replaced by an insulating block 12, which bridges the narrow gap 44 between the electrodes 2 and 3 and has through-holes for accommodating screws 9 and 10.

By means of the joint holder 1, the gap 44 between the electrodes 2 and 3 can be formed so as to be very narrow in the range 0.1 to 3 mm. The gap may either be filled accordingly with the atmosphere of the target-side region of the vacuum chamber or have a corresponding insulating filler.

The electrodes 2 and 3 of the embodiment of Fig. 1 are represented and described in a structure comprising a holding plate with cooling channels and targets 18, 19 and insulators 13, 14 arranged thereon. Alternatively, other electrodes, e.g. metal plates without cooling channels or without insulators 13, 14, may also be provided. Above and beyond that, it is also possible for targets 18 and 19 themselves to be connected up as electrodes, without the need for additional holding plates 15 and 16.

The electrodes 2 and 3 are connected via corresponding electrical lines to an energy or voltage supply 20, which is connected up such that electrode 2 is alternately connected as cathode and the electrode 3 as anode, and vice versa. This alternation is achieved by means of alternating voltage, especially in the medium frequency range, or by means of a bipolar or unipolar pulsed direct current.

Magnet arrangements 4 and 5 are provided on the side of the electrodes 2, 3 facing away from the target or sputtering side such that, together with the electrodes 2, 3, the magnetron arrangement of Fig. 1 is formed.

Fig. 1 shows two different magnet arrangements 4 and 5. However, the same magnet arrangements may be selected for both electrodes 2 and 3.

The magnet arrangement 5, which is shown on the left of Fig. 1, comprises a magnetic yoke 21 of soft-magnetic material, which is formed as a longitudinal, almost cuboid bar, with, again, the length extending perpendicularly to the plane of the diagram.

The magnetic yoke 21 has two opposing principal surfaces 22 and 23, with two rows of bar-shaped permanent magnets 26 and 27 provided at the second principal surface 23. The rows of magnets 26 and 27 are provided in the centre of the width of the magnetic yoke 21 and again extend in the length direction perpendicular to the plane of the diagram. Instead of permanent magnets, other magnets, for example electromagnets, may be provided.

At the long-side face sides, the quadratic shape of the magnetic yoke 21 is modified such that inclined surfaces 24 and 25 are provided, whose surface normals, which are shown in dashed lines in Fig. 1, form an angle α with the surface normal of the second principal surface 23. The angle α has a value of between 30 and 60°, preferably in the range of 45°.

By means of the chosen magnet arrangement 5, magnetic field lines 40 and 41 are formed, which project in a loop from the inclined surfaces 24 and 25 to the magnet rows 26 and 27. The inclined surfaces 24 and 25 of the magnetic yoke 21 cause the magnetic lines lines to be diverted outwardly over the long-side face sides such that especially a markedly effective magnetic field extends over the long-side face sides of the magnet arrangement 5 in the direction of the surface normal of the inclined surfaces 24 and 25. This means that it is possible to also overlap the edge area of the target 19 in the small gap 44 with the magnetic field lines, such that, especially in the edge area of the target 19 close to the gap 44, a plasma channel (so-called race track) may be formed, which contributes to removal of the sputtered material from out of the edge area of the target 19 as well.

On account of the narrowness of the gap 44 created by the joint holder 1 and the advantageous magnet arrangement 5 with sputtering of the target material in the edge area of the narrow gap 44, stationary coating of large-area substrates, i.e., coating of localised substrates, with homogeneous layer formation, is possible.

This is also achieved by the second embodiment of the magnet arrangement 4, whose basic structure corresponds to that of the magnet arrangement 5. Here again, a magnetic yoke 29 with a first principal surface 30 and an opposing second principal surface 31 are provided, at which two rows of bar-shaped permanent magnets 34 and 35 are arranged in the centre of the magnetic yoke 29. The magnetic yoke 29 also has inclined surfaces 32 and 33 corresponding to the inclined surfaces 24 and 25 of the magnet arrangement 5.

The embodiment of the magnet arrangement 4 on the right of Fig. 1 differs from that on the left (magnet arrangement 5) in that a row of permanent magnets 36 and 37, also bar-shaped, is each arranged additionally at the inclined surfaces 32 and 33, the orientation of said permanent magnets being opposed to those of the magnet rows 34 and 35. The orientation of the north and south poles of the magnets 34, 35, 36 and 37 shown in Fig 1 also creates a loop-shaped formation of the magnetic field lines 42 and 43 emanating from the central magnet rows 34 and 35 towards the magnet rows 36 and 37 arranged at the inclined surfaces 32 and 33. The additional arrangement of the magnet rows 36 and 37 can amplify the magnetic field, with the basic shape of the magnetic field lines 40 and 43 retained in a manner corresponding to that of the magnet arrangement 5. The magnet rows 36 and 37 are arranged such that, in each case, a gap or free space is created at the lower edge of the magnet arrangement 4 in the region of the long-side face sides, said gap or free space facilitating the arrangement of magnet arrangement 4, in a manner similar to magnet arrangement 5, very close to the edge area of the corresponding electrode 2 or 3, such that the magnetic field covers the corresponding edge area of the target 18 or 19.

Although Fig. 1 only shows a cross-section through the magnet arrangements 4 and 5 or electrodes 2 and 3 as well as the magnetron arrangement formed thereby, with the length perpendicular to the plane of the diagram, it goes without saying that a corresponding design, as described here with regard to the long-side faces, may also apply to the short sides, such that, for example, the magnet rows 36 and 37, may be formed as a closed ring, with two parallel rows of magnets 34, 35 in between.

As shown by the double-headed arrow 28 in Fig. 1, the magnet arrangements 4 and 5 are preferably formed so as to be mobile, with corresponding devices (not shown) provided for holding and moving the magnetic yokes with the magnets.

The direction in which the magnet arrangements 4 and 5 move is, as shown by double-headed arrow 28, in the embodiment shown in Fig.1 in the width direction, that is, transverse to the longitudinal extension of the magnet arrangements or electrodes 2, 3. The movement may be of the oscillating type, that is, a back-and-forth movement, in order that the magnetic field may cover the whole area of the respective target 18 or 19 and thus may contribute to uniform removal of the target material.

The embodiment in Fig. 1 shows only one magnet arrangement 4 or 5 for each electrode 2 or 3. However, several parallel magnet arrangements 4 or 5 or partial magnet arrangements to form one magnet arrangement per electrode may be provided for each electrode 2 or 3.

The magnet arrangements 4 and 5 of adjacent electrodes 2 or 3 and/or the several partial magnet arrangements for an electrode may be synchronised or different in their movements.

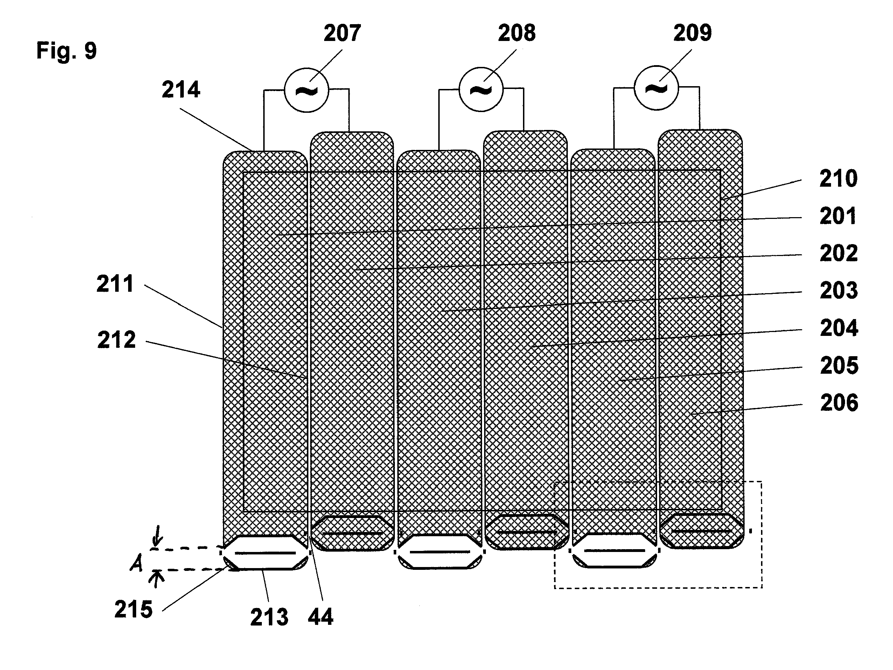

Only two electrodes 2 and 3 are shown in Fig. 1, which are operated alternately as cathode and anode. However, a magnetron or electrode arrangement is also conceivable in which a plurality of electrodes with corresponding magnet arrangements are operated as pairs of cathodes and anodes, as shown below in Fig. 9 to 11.

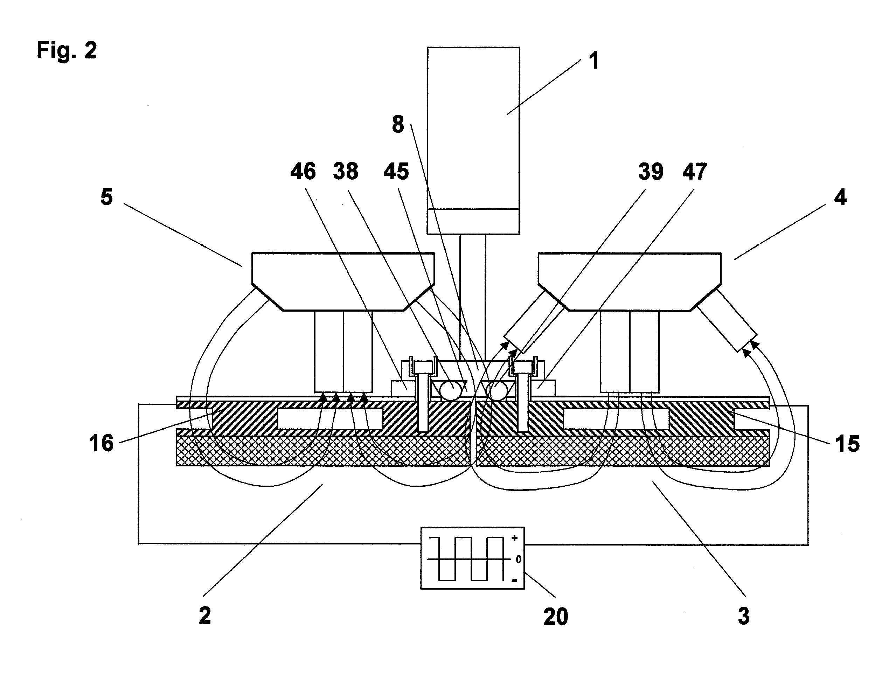

Figs. 2 to 7 show further embodiments of the corresponding magnetron arrangement, with these largely corresponding both in representation and design to the embodiment of Fig. 1, such that a repeated description of identical parts and components is eschewed. The embodiments of Figs. 2 to 7 are thus described merely with reference to the modifications made there.

The embodiments of Figs. 2 to 5 and 7 differ from that of the embodiment shown in Fig. 1 essentially in the fact that the target or sputtering-side space has additionally been separated from the magnet-side space relative to the electrodes 2, 3.

Due to the atmospheric separation of the sputtering or target side of the electrodes 2, 3 from the magnet side, the pressure in the region of the magnet arrangements 4 and 5 may be set higher, for example in a range of approx. 10 mbar, such that discharges may be better avoided there.

The embodiments of Figs. 2 to 5 and 7 differ from each other essentially in the design of a corresponding seal.

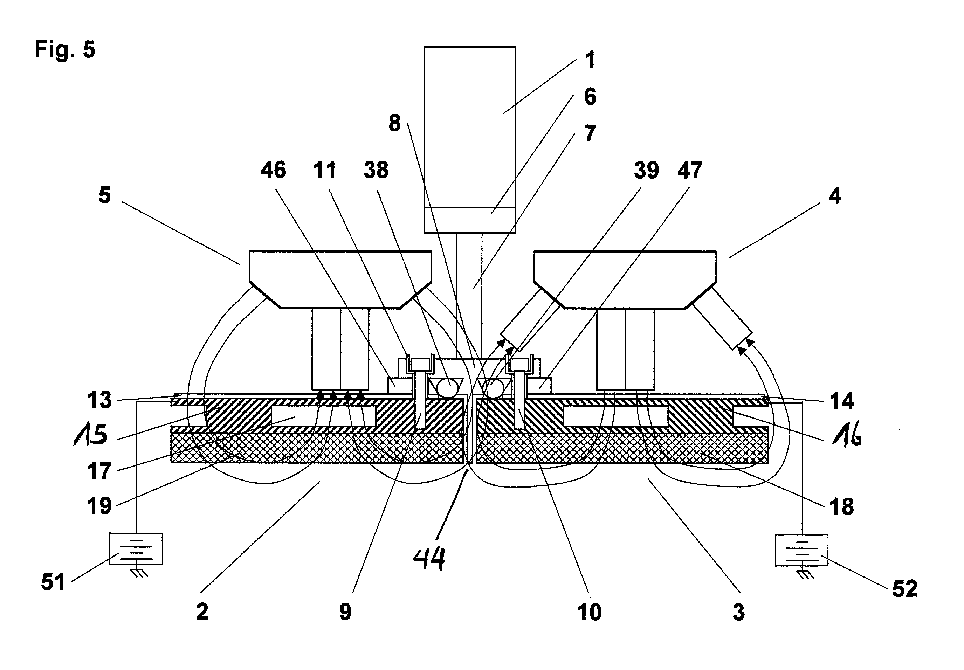

Whereas, in the embodiments of Fig. 2 and 5, the insulator block 12 is replaced by two insulator halves 46 and 47 in order that this may create space for the arrangement of sealing strips or o-rings 38 and 39.

The elastic sealing strips 38 and 39 shown in the embodiments of Fig. 2 and 5 having a circular or oval cross-section are each held on one side by the isolator halves 46 and 47 and on the other side by an appendage 45 integrated into the bottom part 8 of holder 1, whereas, in the thickness direction, they are jammed between the holding plate 15 or 16 and the bottom part 8 of the holder 1.

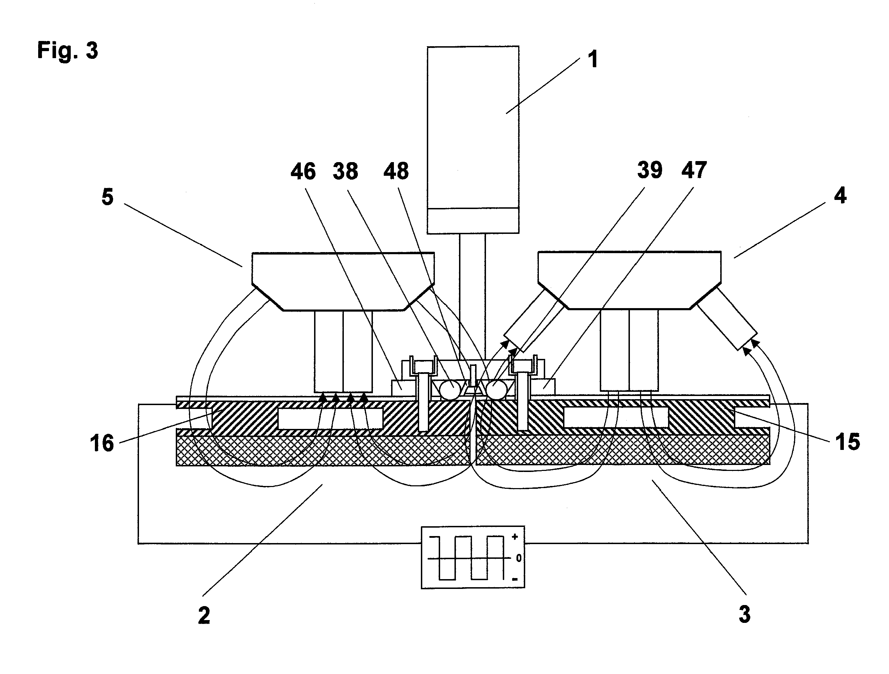

In the embodiment of Fig. 3, the appendage 45 of the embodiments of Fig. 2 and 5 integrated into the bottom part 8 is replaced by a screw-in seal holder 48.

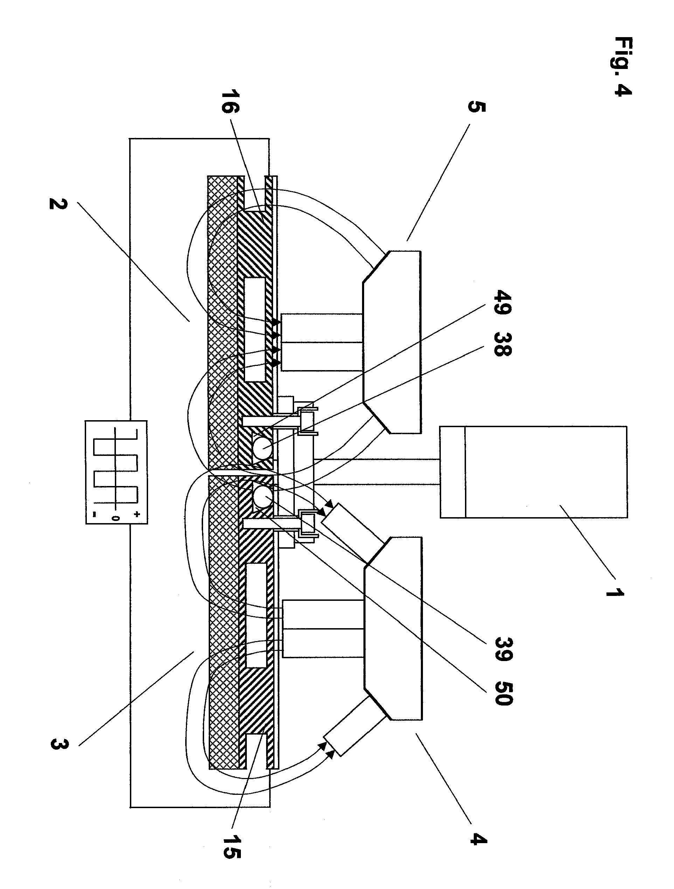

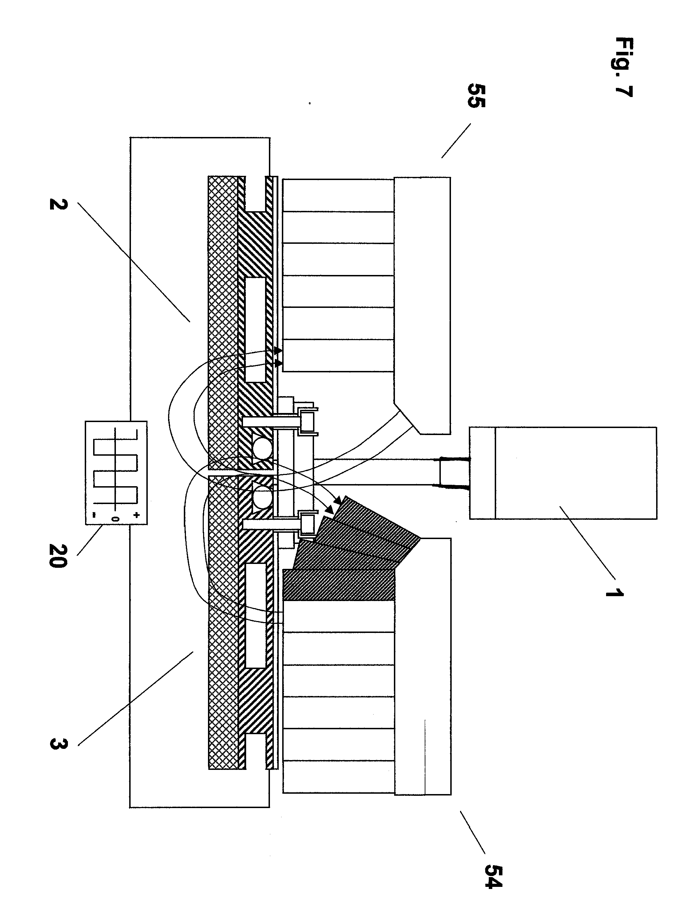

In the embodiments of Fig. 4 and 7 grooves 49 and 50 for accommodating the sealing strips 38 and 39 are provided in each of holding plates 15 and 16 .

The sealing strips 38 and 39 are preferably provided around the electrodes 2 and 3 in the form of o-rings, with a corresponding holder, which then for example comprises only one half of the holder 1, being able to be provided at the face sides of the width direction.

Due to the advantageous holding of the oblong electrodes 2 and 3 along their length by the joint holder 1, very thin electrodes 2 and 3 may also be used, which make it a simple matter for an adequately strong magnetic field to form in the region in front of the targets 18, 19. Despite the thinness of the electrodes 2 and 3 and the large dimensions, especially along the length, the holder of the invention, ensures that no bending or curving of the electrodes, which would have a deleterious effect on the coating quality, occurs.

Fig. 5 to 7 show examples of embodiments which are very similar to the embodiment described in detail with respect to Fig. 1. In addition to the differences mentioned above, the embodiments of Fig. 5 to 7 show additional variations which are described in the following.

The embodiment shown in Fig. 5 is very similar to the embodiment shown in Fig. 2 except for the design of the energy supply. While the adjacent electrodes 2 and 3 of Fig. 2 have one common power supply 20, the electrodes 2 and 3 of the embodiment of Fig. 5 are connected to separate power supplies 51 and 52. Thus, the voltage or potential of the electrodes 2 and 3 can be set individually and independently from each other. Although, this kind of power supply is only shown for the embodiment of Fig. 5, it is evident that such kind of a power supply can also be realized for the other embodiments.

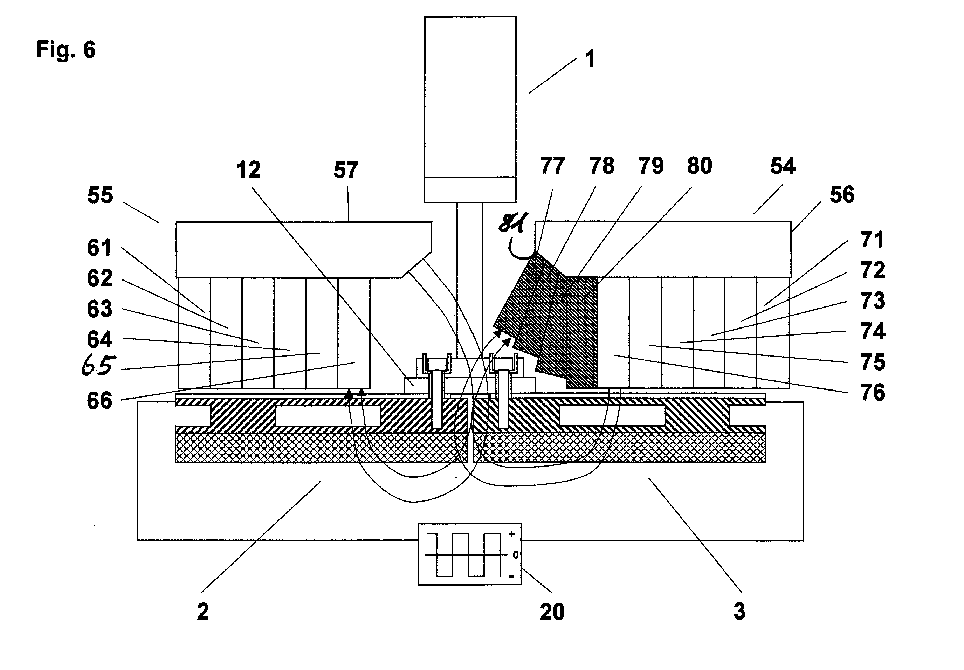

Fig. 6 and 7 differ with respect to the embodiments shown before in the design of the magnet arrangements 54 and 55. While the magnet arrangements 4 and 5 of the previous described embodiments comprise two central rows of magnets 26, 27 or 34, 35, respectively, as well as one outer circumferential magnet ring including magnet rows 36 and 37 (see Fig. 1) the magnet arrangements 54 and 55 comprise several central magnet rows 61 to 66 or 71 to 76, respectively. The magnets of the magnet rows 61 to 66 or 71 to 76 are oriented parallel to each other so that the north pole or the south pole, respectively, of all magnets face in the same direction. For example, the magnets of the magnet rows 71 to 76 of magnet arrangement 54 are oriented such that the south pole is located at the yoke 56, while the north pole is facing towards the electrode 3.

The magnets of the magnet arrangement 55 have an opposite orientation with the north pole located at the yoke 57 and the south pole facing towards the electrode 2.

In addition to the same orientation with respect to polarity, the magnets of the magnet rows 61 to 66 or 71 to 76 also have the same alignment with respect to the disposition in the magnet arrangements 54 or 55.

The magnets of the magnet rows 61 to 66 or 71 to 76 having essentially a cubic shape are aligned perpendicular to the principal surface of the yokes 56 or 57, respectively.

In addition to the magnets of the magnet rows 71 to 76, the magnet arrangement 54 further comprises magnet rows 77 to 80. The magnet rows 77 to 80 surround the magnet rows 71 to 76 and are disposed at the inclined surface of the holder 1 in the outer circumferential region of the yoke 56.

Despite the fact that only that parts of the magnet arrangements 54 and 55 facing towards the common holder 1 of the electrodes 2 and 3 are shown, it is easily understood that the magnet arrangements 54 and 55 have a symmetrical design with respect to their longitudinal axis, similar to the embodiments shown in Fig. 1 to 5.

The orientation of the magnets in the magnet rows 77 to 80 is opposite to the orientation of the magnets in the magnet rows 71 to 76 with respect to polarity so as to form again loop like magnetic field lines.

Although, the orientation of the magnets of the magnet rows 77 to 80 is almost identical or parallel, at least similar, the alignment of the magnets differs from row to row. While the magnets in the magnet row 77 are aligned perpendicular to the inclined surface 81, the magnets of the magnet rows 78 to 80 are adapted in their alignment in order to stepwise (as shown) or continuously approach the alignment of the magnet rows 71 to 76.

Fig. 7 shows an embodiment having the same magnet arrangements 54 and 55 as of the embodiment shown in Fig. 6, while the remaining design is identical to the embodiment shown in Fig. 4. Accordingly, a repeated description is omitted and for the description of the embodiment shown in Fig. 7 it is referred to the description of the embodiments in Fig. 4 and 6.

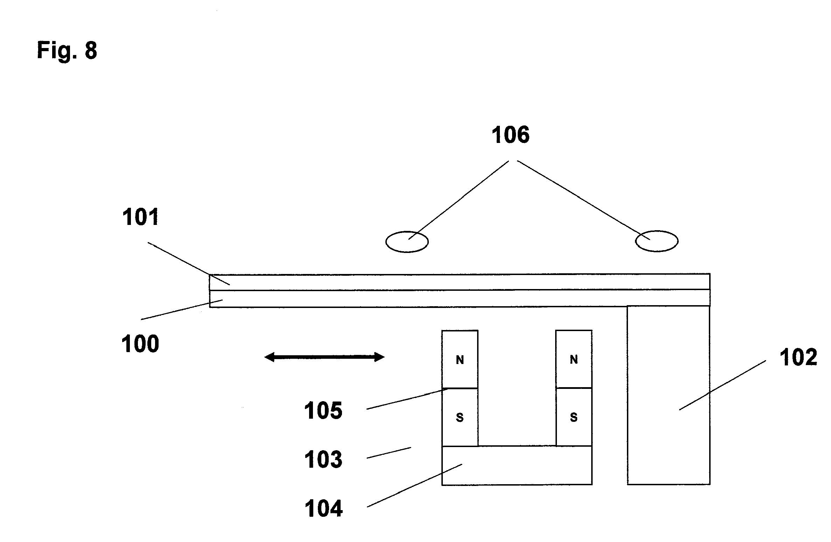

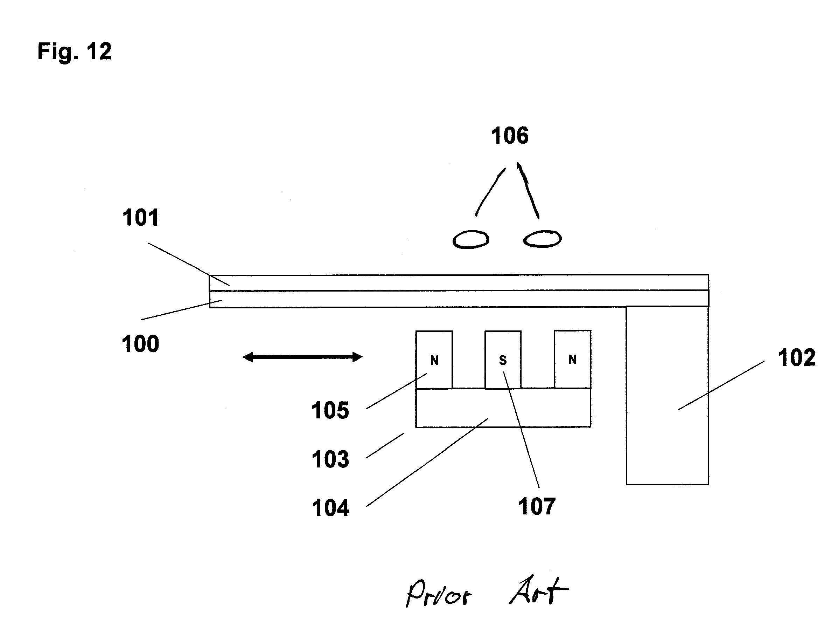

Fig. 8 shows a side elevation of a further embodiment according to the present invention, while Fig. 12 represents a similar magnetron electrode according to prior art. Similar or identical components are designated by the same reference numerals so that a repeated description can be omitted.

The magnetron electrode of Fig. 8 comprises an electrode 100 and a target removably mounted to the target surface of the electrode. At the backside of the electrode opposite to the target surface a magnet arrangement 103 is movably disposed. As indicated by the double arrow of Fig. 8 the magnet arrangement 103 can be reciprocally moved transversely to the length direction of the electrode 100 by a drive mechanism not shown in Fig. 8.

The magnet arrangement 103 comprises an oblong yoke 104 and a rectangular ring of magnets 105 mounted circumferentially on the yoke 104. All magnets 105 of the ring are oriented parallel so that the respective north poles are facing towards the electrode 100 and the target 101. Contrary to the magnet arrangement 103' of the embodiment according to prior art shown in Fig. 12, which comprises a row of magnets 107 in the center of yoke 104, the inventive magnet arrangement shown in Fig. 8 does not contain any magnet being oriented antipodal. Thus, the plasma 106 is concentrated laterally offset from the magnet arrangement according to the invention, while in the embodiment of prior art (Fig. 12) it is generated straight ahead of the magnet arrangement. Accordingly, it is not necessary to move the magnet arrangement 103 up to the very end of the electrode 100 with respect to the width direction to enable sputtering of the marginal or peripheral area of the target 101. Due to lateral plasma formation sputtering in the border area of the target is possible without placing the magnet arrangement directly opposite to the sputtering area. As a consequence, additional structural components such as the enforcement rib 102 shown in Fig. 8 may be disposed at the electrode 100 without detrimentally affecting exploitation of the target. In the embodiment known from prior art (Fig. 12) the provision of the rib 102 however leads to the problem that sputtering of the border area of the target is reduced or impeded because of the different magnetic field leading to detrimental coating properties.

Instead of the ring-like arrangement of the magnets 105 on the yoke 104 or carrier, an arrangement with a single central row of magnets on the yoke or carrier is also conceivable. This could be achieved for example by omitting magnets 105 of the embodiment of Fig. 12 so that only the magnets 107 disposed along the central line of yoke 104.

Fig. 9 to 12 show purely schematic top views of electrode arrangements having planar magnetron electrodes of a different type of the invention.

Fig. 9 shows an embodiment comprising six electrodes 101 to 106. Each pair of adjacent electrodes 101 and 102, 103 and 104, 105 and 106 are connected to a common power supply 207, 208, 209 so as to be alternately switched as cathode or anode.

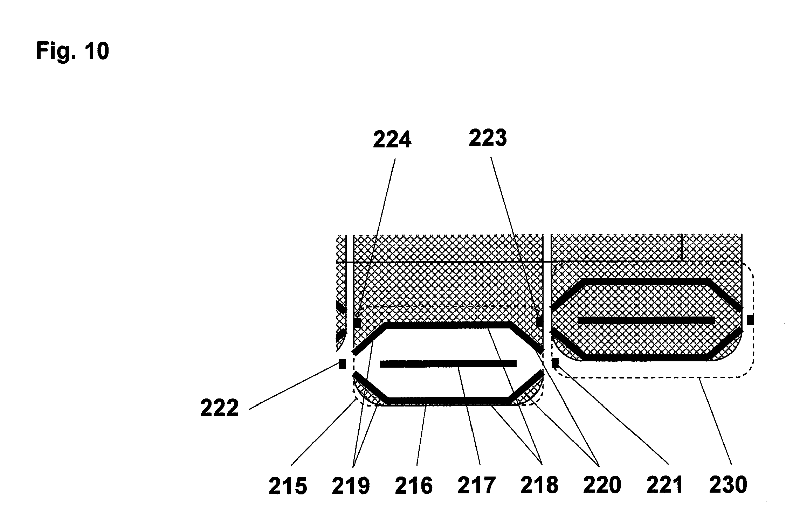

The electrodes 201 to 206 have an oblong plate-like structure with face sides 211, 212, 213, 214. At the longitudinal sides 212 or 211, respectively, the electrodes are disposed adjacent to each other to form a small gap 44 in between. The front faces 213 or 214 of adjacent electrodes are offset to each other. The substrate 210 to be coated is shown as a rectangle with dimensions a little bit smaller than the area covered by all electrodes 201 to 206. At the bottom of Fig. 9 parts of the magnet arrangements are shown in form of partial magnet arrangements 215 which are described with respect to Fig. 10. A plurality of partial magnet arrangements 215 shown in Fig. 9 and 10 are disposed parallel to each other along the length of the electrodes 201 to 206.

The partial magnet arrangement 215 is schematically shown by the dotted lines of Fig. 10. The partial magnet arrangement 215 comprises a partial magnet ring 216 enclosing a central magnet row 217 with opposite magnetic orientation. The partial magnet ring 216 is formed by opposing magnet rows 218 which are arranged parallel to each other. The magnet rows 218 are disposed transversely to the longitudinal direction of the electrode. At the peripheral region at the longitudinal sides of the electrodes the partial magnet ring 216 comprises magnet rows 219 and 220 tapering to each other. However, the tapered sections of the partial magnet ring 216 comprising the magnet rows 219 and 220 do not form a closed ring, but comprise open ends at the longitudinal sides of the electrode.

In order to extend or stretch the plasma ignited in the area within the partial magnet ring 216 to the longitudinal sides of the electrode, additional magnets 221 and 222 are disposed in adjacent partial magnet arrangements 230 as shown on the right side of Fig. 10. Although, additional magnet 221 is part of the partial magnet arrangement 230 of the adjacent electrode, the additional magnet 221 is associated to the partial magnet arrangement 215 with regard to the magnetic effect. Accordingly, the partial magnet arrangement 215 also comprises additional magnets 223 and 224 operating with respect to adjacent partial magnet arrangements, as for example partial magnet arrangement 230. The additional magnets 223 and 224 are moved together with the magnet arrangement, a part of which is formed by the partial magnet arrangement 215. In order to make sure that the additional magnets 221 to 224 actively operate with the adjacent magnet arrangements all partial magnet arrangements belonging to one electrode or magnet arrangement, respectively, as well as adjacent magnet arrangements of neighbouring electrodes are moved synchronously or are located at a common carrier in order to ensure synchronous movement.

The movement of the magnet arrangement or partial magnet arrangement 215 is along the longitudinal axis of the electrodes so that the plasma ignited within the partial magnet ring 216 of each partial magnet arrangement is moved over a part of the target surface so that by the various partial magnet arrangements the whole target surface is covered.

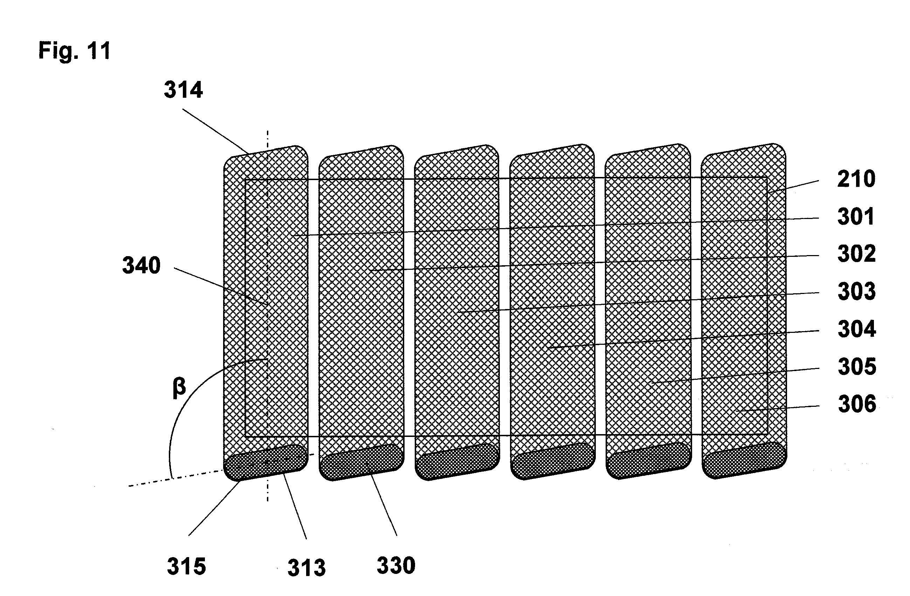

Fig. 11 shows a second electrode arrangement comparable to that one described with respect to Fig. 9 and 10. This embodiment of an electrode arrangement comprises also six electrodes 301 to 306 being disposed adjacent to each other. The only difference with respect to the embodiment shown in Fig. 9 and 10 refers to the alignment of the partial magnet arrangements 315. While the electrodes 201 to 206 of the embodiment shown in Fig. 9 are offset to each other by the distance A with respect to the front faces 213 and 215 in order to enable an offset arrangement of the partial magnet arrangements 215 for the interaction of adj acent partial magnet arrangements 215, the partial magnet arrangements 315 as well as the front faces 313 and 314 of the embodiment shown in Fig. 12 are disposed with an inclination with respect to the longitudinal axis 340. Accordingly, an angle β different from 90 ° is established between the longitudinal axis of the partial magnet arrangements 315 as well as the front faces 313 and 314 on the one side and the longitudinal axis 340 of the electrode on the other side. The inclined design allows provision of interacting partial magnet arrangements of adjacent electrodes in a similar way to the offset design of Fig. 9 to 10.

Although the present invention has been described in detail using the enclosed embodiments, it is clear to a person skilled in the art that, within the scope of protection of the enclosed claims, modifications and amendments, especially in a different type of combination of individual characteristics or in the exclusion of certain characteristics, are possible.

## Claims

1. Planar magnetron electrode for a sputtering device comprising a planar elongated electrode with a target surface, at least one magnet arrangement assigned to said electrode having a carrier and at least a row of magnets or an elongated magnet arranged at said carrier with a magnet pole of a first polarity facing toward said electrode and a magnet pole of an other polarity facing away from said electrode, said magnet arrangement creating a magnetic field and being movable relative to said electrode along a path of movement,
wherein
said magnet arrangement is designed such that said magnetic field projects beyond the circumference of said magnet arrangement such that a plasma can be generated in front of said electrode, said plasma extending in the radial outer marginal area of said at least one lateral side of said electrode and/or beyond said at least one lateral side of said electrode seen from a direction perpendicular to the target surface of the electrode.

2. Magnetron electrode in accordance with claim 1,
wherein
said path of movement of said magnet arrangement is restricted to an area of the electrode such that said magnet arrangement does not project beyond at least one lateral side of the electrode seen from a direction perpendicular to the target surface of the electrode.

3. Magnetron electrode in accordance with claim 1 or 2,
wherein
the magnets are arranged in one or several, especially parallel rows and/or in one or several, especially parallel aligned rings or partial rings.

4. Magnetron electrode in accordance with claim 3,
wherein
the rows, rings and/or partial rings of magnets are aligned with the longitudinal axis of the magnet arrangement parallel or transverse to the length of the electrode.

5. Magnetron electrode in accordance with claim 3,
wherein
at least one ring disposed at the radial outer marginal area of the carrier is provided for.

6. Magnetron electrode in accordance with any of the preceding claims,
wherein
all magnets at least of one row or ring are oriented in the same way with respect to polarity.

7. Magnetron electrode in accordance with any of the preceding claims,
wherein
at least one yoke (21) assigned to the magnets, which connects them, is provided for.

8. Magnetron electrode in accordance with claim 7,
wherein
the magnets (26, 27) are oriented parallel in at least one or two or more parallel rows along the length of the yoke.

9. Magnetron electrode in accordance with claim 8,
wherein
the magnets are arranged centrally to the yoke, especially with respect to the width direction transverse to the length.

10. Magnetron electrode in accordance with any of the preceding claims,
wherein
said magnet arrangement comprises several partial rings of magnets being disposed parallel to each other along the length of the electrode with their longitudinal direction transverse to the length of the electrode.

11. Magnetron electrode in accordance with claim 10,
wherein
said partial ring of magnets has opposing open ends at the length sides of the electrode and a central row of magnets within the partial ring having an opposite orientation of the magnets with respect to polarity.

12. Magnetron electrode in accordance with any of claims 10 or 11,
wherein
between the partial rings in the area of the length side of the electrode one or more magnets having the same orientation as the magnets of the adj acent rings are provided for.

13. Magnetron electrode in accordance with any of the preceding claims,
wherein
the carrier is designed as a yoke.

14. Magnetron electrode in accordance with any of the preceding claims,
wherein
a yoke is provided for as an especially oblong plate, which has a first principal surface (22) and a second principal surface (20) opposite to said first principal surface, which extend along the length and in the direction of the width transverse to the length, with the magnets arranged at the second principal surface and with an inclined surface (24, 25) provided at at least one face side of the plate, the surface normal of that inclined surface has a sub-vector parallel to the surface normal of the second principal surface.

15. Magnetron electrode in accordance with claim 14,
wherein
an inclined surface is provided at at least two face sides, preferably at at least four face sides.

16. Magnetron electrode in accordance with claims 14 or 15,
wherein
said inclined surface with its surface normal is arranged at an angle of 30 to 60°, especially 45°, to the surface normal of the second principal surface.

17. Magnetron electrode in accordance with any of claims 14 to 16,
wherein
magnets (36, 37) are provided at the inclined surface(s) (32, 33) being oriented in the opposite manner to the magnets (34, 35) arranged at the second principal surface (31).

18. Magnetron electrode in accordance with any of claims 14 to 17,
wherein
said magnets extend along the surface normal of the inclined surface and/or second principal surface.

19. Magnetron electrode in accordance with claim 18,
wherein
third magnets are disposed in between first magnets disposed at the second principal surface and second magnets disposed at the inclined surface, said third magnets being oriented either in the same manner as said first or second magnets at the second principal surface or at the inclined surface and changing alignment with respect to inclination to the second principal surface gradually or stepwise from the alignment of said first magnets at the second principal surface to the alignment of said second magnets at the inclined surface.

20. Magnetron electrode in accordance with any of claims 14 to 19,
wherein
the magnetic field lines (40, 41, 42, 43) extend in the form of an arc or loop from the magnets of the second principal surface to the inclined surfaces or to the magnets provided thereat or vice versa, with the exit and inlet points lying on different planes such that the installed height of the magnet arrangement at the at least one face side is lower than at the centre of the magnet arrangement.

21. Magnetron electrode in accordance with any of the preceding claims,
wherein
the magnetic field lines (40, 41, 42, 43) project beyond the face sides of the magnet arrangement parallel or transverse to a direction of movement (28).

22. Magnetron electrode in accordance with any of the preceding claims,
wherein
the magnetic field lines are formed such that the plasma is ignited laterally, at least partially outwardly offset to the face sides of the magnet arrangement.

23. Magnetron electrode in accordance with any of the preceding claims,
wherein
a drive mechanism is provided for driving the magnet arrangement in the direction parallel or transverse to the length of said electrode.

24. Magnetron electrode in accordance with any of preceding claims,
wherein
the electrode comprises at least one of the components of the group comprising side walls, reinforcement ribs, holders and the like, especially being arranged at a longitudinal side of the electrode.

25. Electrode arrangement of a sputtering device with at least two planar electrodes, preferably at least one of them being designed in accordance with any of the preceding claims, the electrodes are operated alternately as sputtering cathodes (2, 3), which are arranged adj acent to each other along their length sides with their face sides facing each other,
wherein
the electrodes are held by at least one, preferably two or more joint holders (1), at their longitudinal sides such that a small gap (44) is formed between them.

26. Electrode arrangement in accordance with claim 25,
wherein
the gap (44) between the electrodes is 0.1 to 5 mm, preferably 0.2 to 3 mm and especially 0.5 to 2 mm.

27. Electrode arrangement of a sputtering device with at least two planar electrodes, preferably at least one of them being designed in accordance with any of the claims 1 to 24, the electrodes are operated alternately as sputtering cathodes (2, 3), which are arranged adj acent to each other along their length sides with their face sides facing each other,
wherein
the gap (44) between the electrodes is 0.1 to 0.9 mm, preferably 0.2 to 0.8 mm and especially 0.5 to 0.6 mm.

28. Electrode arrangement in accordance with any of the claims 25 to 27,
wherein
the electrodes (2, 3) have an insulator opposite the sputtering side (13, 14).

29. Electrode arrangement in accordance with any of the claims 25 to 28,
wherein
the rear space of the electrodes (2, 3) opposite the sputtering side is sealed off from the sputtering side for the purpose of atmospheric separation.

30. Electrode arrangement in accordance with any of the claims 25 to 29,
wherein
sealing means (38, 39), especially o-rings or comparable sealing means, are provided adj acent to the gap, which is formed between the electrodes, especially in a part of the electrode, a part of the holder or separate receptacles.

31. Electrode arrangement in accordance with any of claims 25 to 30,
wherein
a holder for at least one electrode is provided for at a holding region, at least a part of the holder (1) in the direction transverse to the gap (44) being dimensioned to be so small that magnet arrangements are arrangable or traversable in the holding region such that the magnetic field lines project the face side of the electrode at least partially in the holding region.

32. Electrode arrangement in accordance with any of claims 25 to 31,
wherein
the holder (1) comprises at least a T-profile, a double T-profile or a structure with at least one region of reduced width extension of the holder, such region having a height corresponding at least to the installed height of a magnet arrangement assigned to the electrode arrangement.

33. Electrode arrangement in accordance with any of claims 25 or 31 to 32,
wherein
the holder (1) comprises a separation element extending between the electrodes and/or the targets.

34. Electrode arrangement in accordance with any of claims 25 to 33 or the preamble of claim 25,
wherein
a magnet arrangement assigned to an electrode comprises magnets associated to a magnet arrangement of an adj acent electrode such that a plasma generated in front of the adj acent electrode being extended beyond at least one lateral side of the adjacent electrode.

35. Electrode arrangement in accordance with claim 34,
wherein
a first magnet arrangement of a first electrode comprises several partial rings of magnets being disposed parallel to each other along the length of the first electrode with the longitudinal direction of the rings transverse to the length of the first electrode, wherein said partial rings of magnets have opposing open ends at the length side of the electrode and each partial ring has a central row of magnets within the partial ring having an opposite orientation of the magnets with respect to polarity, and wherein
between the partial rings in the area of the length side of the first electrode one or more magnets having the same orientation as the magnets of the adj acent rings are provided for in order to complement a partial ring of magnets of a second magnet arrangement of a second electrode being adjacent to a first electrode.

36. Electrode arrangement in accordance with any of claims 34 or 35,
wherein
adjacent electrodes and/or assigned magnet arrangements are offset to each other with respect to their face sides.

37. Electrode arrangement in accordance with any of claims 35 to 36,
wherein
rows, rings and/or partial rings of said magnet arrangements being disposed transverse to said length direction of said electrode are inclined to a width direction of said electrode.

38. Electrode arrangement in accordance with any of claims 34 to 37,
wherein
the magnet arrangements of adjacent electrodes are driven synchronously or arranged at a common carrier.

39. Sputtering device for the coating of large-area parts, especially in the stationary state, with a magnetron electrode in accordance with any of the claims 1 to 24 and/or an electrode arrangement in accordance with any of the claims 25 to 38.

40. Sputtering device in accordance with claim 39,
wherein
the electrodes (2, 3) are formed as flat, oblong plates, with the magnet arrangements being almost of similar length and having a reduced extension in the width direction, and formed such that they are movable transverse to the length of the electrodes.

41. Sputtering device in accordance with claim 39,
wherein
the electrodes (2, 3) are formed as flat, oblong plates, with the magnet arrangements being almost of similar width and/or length or having a reduced extension in the width direction, and formed such that they are movable transverse to the width of the electrodes.
